# EUROPÄISCHE PATENTANMELDUNG

(11) **EP 0 905 883 A2**
(43) Veröffentlichungstag der Anmeldung: **31.03.1999**
(21) Anmeldenummer: 98116208.4
(22) Anmeldetag: 27.08.1998
(51) Int. Cl.: H03G 1/04

(54) **Temperaturkompensationsschaltung für Feldeffekttransistor-Verstärkerschaltungen**

(30) Priorität: 29.09.1997 DE 19742954
(71) Anmelder: FRAUNHOFER-GESELLSCHAFT ZUR FÖRDERUNG DER ANGEWANDTEN FORSCHUNG E.V., 80636 München (DE)
(72) Erfinder: Langer, Peter, Dipl.-Ing., D-80992 München (DE)
(74) Vertreter: Schoppe, Fritz, Dipl.-Ing.

(57) **Zusammenfassung**

Eine Temperaturkompensationsschaltung für eine Feldeffekttransistor-Verstärkerschaltung wird durch eine Stromerfassungseinrichtung (22) zum Erfassen des Ist-Drainstroms des Feldeffekttransistors (20) und durch eine Reglereinrichtung (24) realisiert, die einen Eingang, der mit einem Ausgang der Stromerfassungseinrichtung (22) verbunden ist, und einen Ausgang aufweist, der mit einem Steuereingang (G1) des Feldeffekttransistors (20) verbunden ist, wobei die Regelungseinrichtung (24) zur Regelung des Ist-Drainstromes des Feldeffekttransistors (20) auf den Soll-Drainstrom vorgesehen ist, wobei der Soll-Drainstrom einem solchen Drainstrom entspricht, bei dem der Zusammenhang zwischen Steilheit und Drainstrom des Feldeffekttransistors (20) im wesentlichen temperaturunabhängig ist.

## Beschreibung

Die vorliegende Erfindung bezieht sich auf eine Temperaturkompensationsschaltung für spannungsgesteuerte Verstärker und insbesondere auf eine Temperaturkompensationsschaltung für Feldeffekttransistor-Verstärkerschaltungen.

Spannungsgesteuerte Verstärker finden ein breites Anwendungsgebiet z. B. in Empfängerschaltungen von Radios und Handys. In diesen Anwendungsfällen werden spannungsgesteuerte Verstärker verwendet, um ausgehend von stark schwankenden Eingangspegeln den Empfangs- bzw. Eingangssignalpegel auf einen vordefinierten Wert anzuheben, wobei mittels einer automatischen Verstärkungsregelung (AGC; AGC = automatic gain control) Pegelunterschiede verschieden großer Empfangs- bzw. Eingangssignale ausgeglichen werden sollen.

Es stehen gegenwärtig mehrere mögliche Ausführungen von geregelten HF-Verstärkerstufen zur Verfügung, wobei sowohl bei Bipolar- als auch Feldeffekttransistoren die Abhängigkeit der Steilheit vom Arbeitspunkt des Transistors ausgenutzt wird. Die Änderung der Verstärkung beruht hierbei auf der Abhängigkeit der Steilheit des jeweiligen Verstärkerelements vom Betriebsstrom. Im allgemeinen ergibt sich die stärkste Änderung und damit die größte Abhängigkeit der Steilheit im Bereich einer geringen Betriebsstromänderung.

Folglich kann die Verstärkungsregelung bei Bipolartransistor- bzw. MOSFET-Verstärkerstufen durch die Verschiebung des Arbeitspunktes des Transistors vorgenommen werden oder es können FETs mit mehreren Steuereingängen (z. B. Dual-Gate-MOSFETS) verwendet werden.

Die Realisierung von spannungsgesteuerten Verstärkern für die Anwendung im Hochfrequenzbereich erfolgt beispielsweise mit Dual-Gate-MOSFETs oder, wenn besonders hohe Verstärkungen benötigt werden, mit integrierten Verstärkern, wie z. B. dem HPMX-3002 von Hewlett-Packard. Sowohl einzelne Transistoren als auch integrierte Verstärker weisen eine deutliche Abhängigkeit des Zusammenhangs zwischen der Regelspannung und der Verstärkung, d. h. der Kennlinie, von der Temperatur auf. Eine solche Temperaturabhängigkeit ist unbedeutend, wenn nur ein Interesse an der Konstanz einer Ausgangsleistung besteht.

Werden jedoch spannungsgesteuerte Verstärker derart verwendet, daß die Regelspannung des Verstärkers als Meßgröße ausgewertet wird, wie es beispielsweise bei Festphasenoszillatoren für Oberflächenwellensensoren der Fall ist, so darf sich die Kennlinie des Verstärkers nicht oder nur sehr wenig mit der Temperatur ändern.

Im Gegensatz zu einer Temperaturstabilisierung von Bipolartransistorverstärkern, die im allgemeinen durch eine Stromstabilisierung mit Hilfe eines Emitterwiderstandes und eines Basisspannungsteilers erreicht wird, ist bei Feldeffekttransistoren dieses Verfahren nicht anwendbar, da Feldeffekttransistoren einen negativen Temperaturkoeffizienten aufweisen, wodurch bei steigender Temperatur und sonst gleichen Bedingungen der Drainstrom eines Feldeffekttransistors sinkt. Dieser Effekt wird beispielsweise bei der Parallelschaltung von Leistungs-MOSFETs ausgenutzt. Bei Kleinsignal-Feldeffekttransistoren ändert sich mit der Temperatur auch die für Verstärker ausschlaggebende Größe der Steilheit, d. h. der Änderung des Drainstroms über der Gatespannung, wobei die Steilheit den eigentlichen Steuereffekt eines Feldeffekttransistors kennzeichnet.

Aus der JP07-162241A ist eine Temperaturkompensationsschaltung für einen Feldeffekttransistorverstärker bekannt, die einen Widerstand in Reihenschaltung zum Drain des Feldeffekttransistors aufweist, um durch Messen der über diesen Widerstand abfallenden Spannung mittels eines Operationsverstärkers ein vom Drainstrom abhängiges Signal zu erzeugen, das als Eingangssignal eines Reglers verwendet wird, dessen Ausgang mit dem Gate des Feldeffekttransistors verbunden ist, um den Drainstrom auf einen konstanten Wert zu regeln.

Aus der JP06-29751A ist eine Temperaturkompensationsschaltung für einen Dual-Gate-MOSFET bekannt.

Ausgehend von diesem Stand der Technik liegt der vorliegenden Erfindung daher die Aufgabe zugrunde, eine Temperaturkompensationsschaltung für eine Feldeffekttransistor-Verstärkerschaltung zu schaffen, um im gesamten Betriebstempematurbereich eine vollständige Temperaturkompensation zu erreichen.

Diese Aufgabe wird durch eine Temperaturkompensationsschaltung für eine Feldeffekttransistor-Verstärkerschaltung gemäß Anspruch 1 gelöst.

Die vorliegende Erfindung schafft eine Temperaturkompensationsschaltung für eine Feldeffekttransistor-Verstärkerschaltung, mit folgenden Merkmalen: einer Stromerfassungseinrichtung zum Erfassen des Ist-Drainstroms des Feldeffekttransistors; einer Regelungseinrichtung mit einem Eingang, der mit einem Ausgang der Stromerfassungseinrichtung verbunden ist, und einem Ausgang, der mit einem Steuereingang des Feldeffekttransistors verbunden ist, zur Regelung des Ist-Drainstroms des Feldeffekttransistors auf einen Soll-Drainstrom, wobei der Soll-Drainstrom einem solchen Drainstrom entspricht, bei dem der Zusammenhang zwischen Drainstrom und Steilheit des Feldeffekttransistors im wesentlichen temperaturunabhängig ist.

Besonders vorteilhaft ist die vorliegende Erfindung bei solchen Anwendungen einsetzbar, bei denen die Regelspannung eines Spannungsgesteuerten Verstärkers als Meßgröße ausgewertet wird, beispielsweise zur Dämpfungsmessung in einem geschlossenen Regelkreis. Die erfindungsgemäße Temperaturkompensationsschaltung ist insbesondere in solchen Verstärkerschaltungen vorteilhaft einsetzbar, die mittels MOS-Feldeffekttransistoren (MOSFET) oder Dual-Gate-MOS-Feldeffekttransistoren (Dual-Gate-MOSFET) realisiert sind.

Der vorliegenden Erfindung liegt die Erkenntnis zugrunde, daß eine vollständige Temperaturkompensation, d. h. beispielsweise eine vollständige Temperaturunabhängigkeit der Meßergebnisse bei der oben genannten Dämpfungsmessung, und damit das Verstärkungsverhalten eines Feldeffekttransistors über den gesamten Betriebstemperaturbereich desselben erreicht werden kann, wenn der Drainstrom des verwendeten Feldeffekttransistors auf einen Wertebereich eingestellt und geregelt wird, bei dem die Beziehung zwischen der Steilheit und dem Drainstrom eines Feldeffekttransistors im wesentlichen vollständig temperaturunabhängig ist.

Bei bevorzugten Ausführungsbeispielen der vorliegenden Erfindung kann die Stromerfassungseinrichtung durch eine Stromspiegelschaltung realisiert sein, während die Reglereinrichtung zum Regeln des Drainstroms durch einen Proportional-Integral-Regler (PI-Regler) ausgebildet sein kann, der vorzugsweise im aperiodischen Grenzfall betrieben wird.

Somit kann gemäß der vorliegenden Erfindung eine wesentliche Verbesserung der Temperaturstabilität bis hin zu einer vollständigen Temperaturkompensation über den gesamten Betriebstemperaturbereich des Halbleiterelements mittels einer relativ unaufwendigen Temperaturkompensationsschaltung erreicht werden.

Bevorzugte Weiterbildungen der vorliegenden Erfindung sind in den Unteransprüchen definiert.

Bevorzugte Ausführungsbeispiele der vorliegenden Erfindung werden nachfolgend unter Bezugnahme auf die beiliegenden Zeichnungen näher erläutert. Es zeigen:
- Fig. 1: eine graphische Darstellung des Zusammenhangs zwischen der Steilheit und dem Drainstrom eines Dual-Gate-MOSFET in Abhängigkeit von der Temperatur;
- Fig. 2: ein prinzipielles Blockschaltbild einer erfindungsgemäßen Temperaturkompensationsschaltung für eine Feldeffekttransistor-Verstärkerschaltung;
- Fig. 3: ein detailliertes Schaltbild der Temperaturkompensationsschaltung für eine Feldeffekttransistor-Verstärkerschaltung von Fig. 2.

Im folgenden wird nun die vorliegende Erfindung anhand eines bevorzugten Ausführungsbeispiels derselben, das sich auf einen Dual-Gate-MOSFET bezieht, näher erläutert. Es ist jedoch offensichtlich, daß die erfindungsgemäße Temperaturkompensationsschaltung auch für andere Feldeffekttransistoren verwendbar ist.

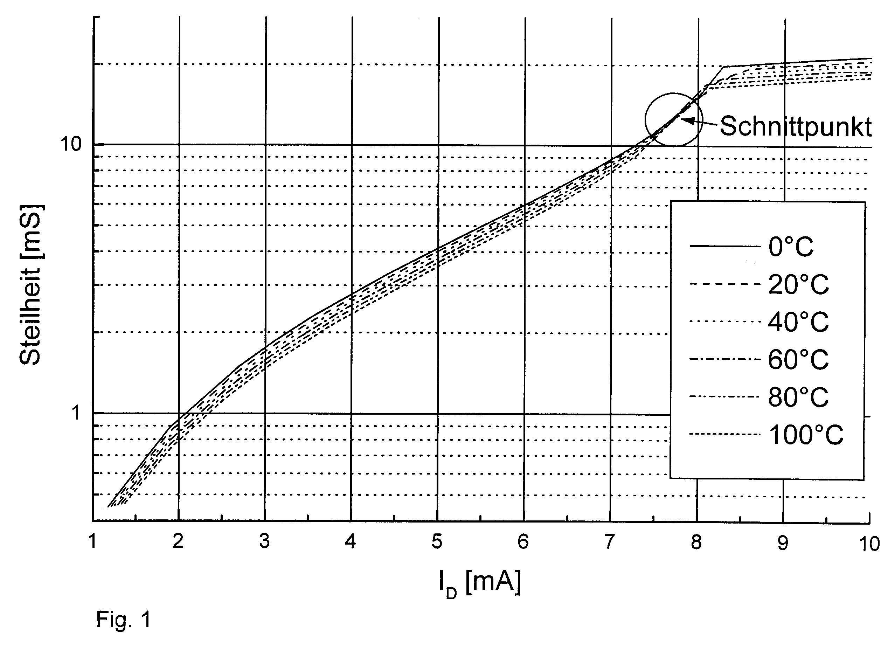

In Fig. 1 ist die Beziehung zwischen der Steilheit [mS] und dem Drainstrom I_{D} [mA] eines MOSFET in Abhängigkeit von der Temperatur graphisch dargestellt. Der Erfinder hat sowohl bei der Simulation als auch experimentell überraschenderveise beobachtet, daß der Zusammenhang zwischen dem Drainstrom I_{D} und der Steilheit gₘ nahezu temperaturunabhängig ist, wobei aus Fig. 1 ein Bereich zu entnehmen ist, in dem die Temperaturabhängigkeit nahezu Null ist (Schnittpunkt). Da die Steilheit den eigentlichen Steuereffekt eines MOSFET kennzeichnet, ist es nun erwünscht, den Drainstrom I_{D} eines MOSFET in dem Bereich zu halten, in dem der Zusammenhang zwischen Drainstrom I_{D} und Steilheit gₘ keine Temperaturabhängigkeit aufweist.

Das Prinzip der Temperaturstabilisierung bzw. Temperaturkompensation einer Feldeffekttransistor-Verstärkerschaltung basiert auf der Messung des Drainstromes I_{D} als Istwert für einen Regler, z. B. einen PI-Regler, der den Drainstrom I_{D} durch eine geeignete Steuergröße (z. B. die Gate-Spannung des MOSFET) konstant hält. Der Sollwert für den Regler wird für einen Verstärker mit fester Verstärkung zweckmäßigerweise so gewählt, daß der Drainstrom I_{D} im Bereich des Schnittpunktes (siehe Fig. 1) liegt. Bei einem regelbaren Verstärker findet der Sollwert des Drainstroms I_{D} als Stellgröße Verwendung.

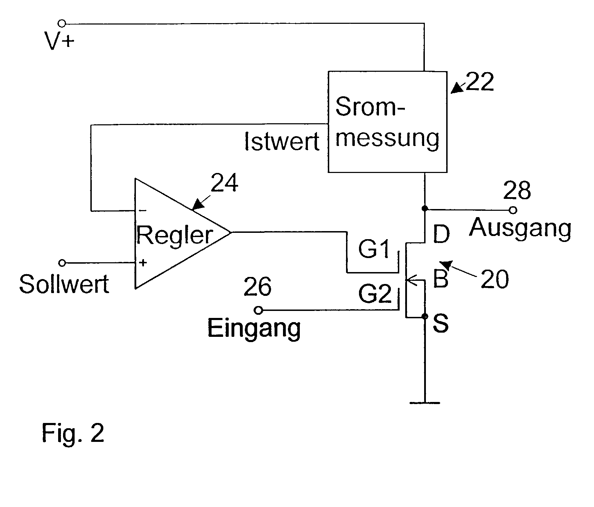

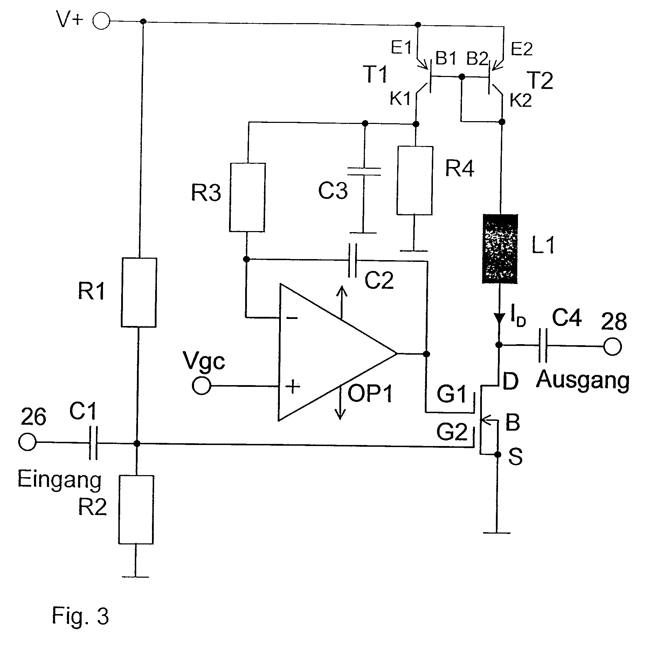

Anhand der Fig. 2 und 3 wird nun ein bevorzugtes Ausführungsbeispiel der erfindungsgemäßen Temperaturkompensationsschaltung für eine MOS-Feldeffekttransistor-Verstärkerschaltung näher beschrieben.

In Fig. 2 ist mit 20 ein Dual-Gate-MOSFET einer Feldeffekttransistor-Verstärkerschaltung dargestellt. Der Sourceanschluß S des MOSFET 20 liegt auf Masse, während zwischen den Drainanschluß D des MOSFET 20 und eine Versorgungsspannung V₊ eine Stromerfassungseinrichtung 22 geschaltet ist. Der Ausgang der Stromerfassungseinrichtung, auf dem ein den erfaßten Strom darstellendes Signal vorliegt, ist mit einem Eingang eines Regler 24 verbunden. Ein zweiter Eingang des Reglers 24 ist mit einem Sollwert beaufschlagbar. Der Ausgang des Reglers 24 ist mit einem ersten Gateanschluß G1 des Dual-Gate-MOSFET 20 verbunden. Ein zweiter Gateanschluß G2 des MOSFET 20 ist mit dem Eingang 26 der Verstärkerschaltung verbunden. Der Ausgang 28 der Verstärkerschaltung ist mit dem Drainanschluß D des MOSFET 20 verbunden. Ein Bulk-Anschluß B des MOSFET 20 ist ebenfalls mit Masse verbunden.

Im folgenden wird nun die prinzipielle Funktionsweise der oben beschriebenen Temperaturkompensationsschaltung für MOSFET-Verstärkerschaltungen näher ausgeführt.

Durch die an der Stromerfassungseinrichtung 22 anliegende Versorgungsspannung V₊ wird ein Drainstrom I_{D} des MOS-Feldeffekttransistors 20 bewirkt. An dem Ausgang der Stromerfassungseinrichtung 22 wird ein Signal, Istwert, erzeugt, das den Drainstrom I_{D} an dem Drainanschluß D des MOSFET 20 darstellt. Dieses Signal wird bei dem dargestellten Ausführungsbeispiel dem invertierenden Eingang eines Differenzverstärkers, der den Regler 24 darstellt, zugeführt. Dem nicht invertierenden Eingang des Differenzverstärkers wird ein Signal zugeführt, das dem Sollwert des Drainstroms I_{D} entspricht.

Das sich am Ausgang des Reglers 24 einstellende Signal wird daraufhin einem geeigneten Steueranschluß des MOSFET 20, d. h. bei dem dargestellten Ausführungsbeispiel, dem Gateanschluß G1 des MOSFET, zugeführt, wodurch der Drainstrom I_{D} des MOSFET 20 immer auf einem durch den Sollwert V_{GC} vorbestimmten festen Pegel gehalten wird. Dieser Pegel für den Drainstrom I_{D} entspricht zweckmäßigerweise dem Drainstrom I_{D} im Schnittpunkt (siehe Fig. 1), bei dem der Zusammenhang zwischen Steilheit und Drainstrom des MOS-Feldeffekttransistors über dem gesamten Betriebstemperaturbereich der Verstärkeranordnung im wesentlichen vollständig temperaturunabhängig sind. Ein an dem Eingang 26 der Verstärkeranordnung anliegendes Eingangssignal wird in den Gateanschluß G2 des MOS-Feldeffekttransistors 20 eingespeist und daraufhin von der MOSFET-Verstärkeranordnung verarbeitet bzw. verstärkt und ist am Ausgang 28 der Verstärkeranordnung als Ausgangssignal abgreifbar.

Durch die Erfassung des Istwertes des Drainstroms des MOSFETs und die Regelung der am Gateanschluß des MOSFETs anliegenden Steuerspannung auf der Basis des erfaßten Drainstroms sowie eines Sollwertes für den Drainstrom ist es möglich, unabhängig von der Temperatur, gleichbleibende Verstärkungseigenschaften der Feldeffekttransistor-Verstärkerschaltung zu erhalten. Sowohl der Drainstrom als auch die Steilheit eines MOSFET ändern sich mit der Temperatur, wodurch sich ohne Temperaturkompensation die Verstärkungseigenschaften ändern. Daher wird gemäß der vorliegenden Erfindung der Drainstrom durch die in Fig. 2 dargestellte Regeleinrichtung stabilisiert, d h. auf den Sollwert geregelt. Da der Drainstrom auf einen Sollwert geregelt wird, der in einem Bereich liegt, in dem der Zusammenhang zwischen Drainstrom und Steilheit im gesamten Betriebstemperaturbereich im wesentlichen temperaturunabhängig ist, beeinflussen Temperaturschwankungen das Verstärkungsverhalten der Verstärkerschaltung nicht.

In Fig. 3 ist nun die Temperaturkompensationsschaltung für eine MOS-Feldeffekttransistor-Verstärkerschaltung detaillierter dargestellt.

Bei dem dargestellten Ausführungsbeispiel ist die Versorgungsspannung V₊, die von einer Strom-/Spannungsversorgungsquelle (nicht gezeigt) bereitgestellt wird, über einen ersten Widerstand R1 mit dem zweiten Gateanschluß G2 des Dual-Gate-MOSFET 20 verbunden. Über einen zweiten Widerstand R2 ist dieser Gateanschluß G2 des MOSFET 20 mit Masse verbunden. Die beiden Widerstände R1, R2 bilden bzgl. der Spannung V₊ einen Spannungsteiler, um dem MOSFET in einen für die Anwendung günstigen Bereich zu bringen. Der Eingang 26 der Verstärkerschaltung ist über einen Koppelkondensator C1 mit dem zweiten Gateanschluß G2 des MOSFET 20 verbunden.

Wie es in Fig. 3 dargestellt ist, ist bei diesem Ausführungsbeispiel die Stromerfassungseinrichtung durch eine Stromspiegelschaltung gebildet, die zwei Bipolartransistoren T₁, T₂ aufweist. Derartige Stromspiegelschaltungen sind in der Technik bekannt. Es ist jedoch offensichtlich, daß neben der dargestellten Stromspiegelschaltung andere Stromerfassungseinrichtungen verwendet werden können.

Die Emitteranschlüsse E1 und E2 der zwei Bipolartransistoren T1, T2 sind mit der Versorgungsspannung V₊ verbunden. Der Basisanschluß B1 des ersten Bipolartransistors T1 ist mit dem Basisanschluß B2 des zweiten Bipolartransistors T2 verbunden, wobei der Kollektoranschluß K2 des Bipolartransistors T2 ferner mit dessen Basisanschluß B2 rückgekoppelt ist. Der Kollektoranschluß K2 des Bipolartransistors T2 ist über eine Induktivität L1 mit dem Drainanschluß D des MOSFET 20 verbunden. Der Drainanschluß D des MOSFET 20 ist ferner über einen Koppelkondensator C4 mit dem Ausgang 28 der Schaltungsanordnung verbunden. Der Sourceanschluß S und der Bulk-Anschluß B des MOSFET 20 sind miteinander verbunden und liegen auf Masse.

Der Kollektoranschluß K1 des Bipolartransistors T1 ist über einen dritten Widerstand R3 mit dem invertierenden Eingang eines Operationsverstärkers OP1 verbunden. Ferner ist der Kollektoranschluß K1 über eine Parallelschaltung eines dritten Kondensators C3 und eines vierten Widerstandes R4 mit Masse verbunden. Der invertierende Eingang eines Operationsverstärkers OP1 ist über einen zweiten Kondensators C2 mit dem Ausgang des Operationsverstärkers OP1 verbunden, wobei der Ausgang des Operationsverstärkers OP1 ferner mit dem Gateanschluß G1 des Feldeffekttransistors 20 verbunden ist. An dem nicht-invertierenden Eingang des Operationsverstärkers OP1 liegt ein Signal V_{GC} an. Der Operationsverstärker OP1 , der zweite Kondensator C2 und der dritte Widerstand R3 stellen in der erläuterten Verschaltung einen Proportional-Integral-Regler (PI-Regler) dar, der bei diesem Ausführungsbeispiel den Regler 24 bildet.

Im folgenden wird nun die Funktionsweise der in Fig. 3 dargestellten Temperaturkompensationsschaltung für eine MOSFET-Verstärkerschaltung beschrieben.

Bei dem bevorzugten Ausführungsbeispiel wurde ein Dual-Gate-MOSFET gewählt, da dieser eine Trennung des Hochfrequenz- und des Steuerkreises zuläßt. Der MOS-Feldeffekttransistor 20 wird mittels des aus den Widerständen R1, R2 gebildeten Spannungsteilers der Spannung V₊ am Gate G1 des Transistors T3 in einen für die Anwendung günstigen Arbeitsbereich gebracht. Die Stromspiegelschaltung, die aus den Transistoren T1, T2 besteht, spiegelt den Drainstrom I_{D} in den Regelkreis. Aufgrund der Kurzschlußbildung zwischen Kollektor K2 und Basis B2 arbeitet der Transistor T2 stets im aktiven Bereich. Die Basis-Emitter-Spannung ist zwangsweise für beide Transistoren T1, T2 gleich, so daß bei gleichen Transistorsystemen und gleicher Temperatur auch die Kollektorströme der Transistoren übereinstimmen.

Dieser Spiegelstrom, der durch den Kollektorstrom des Transistors T1 gebildet ist, erzeugt über den Widerstand R4 einen Spannungsabfall, der den Istwert des Drainstroms I_{D} darstellt. Dieser Spannungsabfall wird an den PI-Regler, der durch den mit dem Widerstand R3 und den Kondensator C2 beschalteten Operationsverstärker gebildet ist, angelegt. Die charakteristischen Größen des Reglers sind vorzugsweise so eingestellt, daß der Regler im aperiodischen Grenzfall arbeitet. Der an dem Kollektoranschluß K1 des Bipolartransistors T1 anliegende Kondensator C3 schließt störende Hochfrequenzreste kurz, die sich negativ auf das Verhalten des PI-Reglers auswirken könnten. Das am Ausgang des PI-Reglers anliegende Signal beeinflußt über den Gateanschluß G1 des Feldeffekttransistors 20 den Drainstrom I_{D} durch denselben. Der Sollwert für den Drainstrom I_{D} wird dem PI-Regler an dem nicht-invertierenden Eingang des Operationsverstärkers OP1 als Signal (Spannung) V_{GC} zugeführt. Im Falle einer festen Verstärkerstufe wird das Signal V_{GC} auf einen festen Wert im Bereich des Schnittpunktes (siehe Fig. 1) eingestellt, wohingegen bei einem regelbaren Verstärker hierdurch die Einstellung der Verstärkung vorgenommen wird.

Die Kondensatoren C1 und C4 dienen zur Abtrennung der Gleichstromwege der Anordnung und stellen für das HF-Nutzsignal einen Kurzschluß dar, um das HF-Eingangssignal am Eingang der Anordnung einkoppeln und am Ausgang der Anordnung das HF-Ausgangssignal auskoppeln zu können. Die Induktivität L1 stellt für die Hochfrequenzsignale einen sehr großen bzw. unendlichen Widerstand dar, wodurch verhindert wird, daß das HF-Nutzsignal über die Gleichstromzuführungen abfließt, um das gesamte HF-Ausgangssignal über den Koppelkondensator C4 an dem Ausgang bereitstellen zu können.

Die hierin beschriebene Kompensationsschaltung ist beispielsweise für den Aufbau eines Festphasenoszillators zur Auswertung eines Oberflächenwellensensors in der Meßtechnik vorteilhaft einsetzbar. Bei einem solchen Oszillator wird der Verstärker mit einem Filterelement, z. B. einem Oberflächenwellensensor, rückgekoppelt. Mit Hilfe eines Reglers wird die Ausgangsleistung auf einen bestimmten Wert geregelt. Hierzu beeinflußt der Regler die Verstärkung derart, daß dieselbe genauso groß ist, wie die Dämpfung des Filterelements. Die dazu notwendige Regelspannung ist ein Maß für die Dämpfung und damit für die Meßgröße.

Die erfindungsgemäße Temperaturkompensationsschaltung ist vorteilhaft für spannungsgesteuerte Verstärkerschaltungen für Hochfrequenzsignale, z. B. 50 bis 120 MHz, einsetzbar. Durch die vorliegende Erfindung kann eine weitgehende Temperaturunabhängigkeit erreicht werden, wobei bei einem spannungsgesteuerten Verstärker (VCA; VCA = voltage controlled amplifier) der Verstärkungsfaktor in Abhängigkeit von einer von außen zugeführten Regelspannung (gain control voltage) variiert werden kann.

## Patentansprüche

1. Temperaturkompensationsschaltung für eine Feldeffekttransistor-Verstärkerschaltung mit folgenden Merkmalen:
einer Stromerfassungseinrichtung (22) zum Erfassen des Ist-Drainstroms des Feldeffekttransistors (20); und
einer Reglereinrichtung (24) mit einem Eingang, der mit einem Ausgang der Stromerfassungseinrichtung (22) verbunden ist, und einem Ausgang, der mit einem Steuereingang (G1) des Feldeffekttransistors (20) verbunden ist, zur Regelung des Ist-Drainstromes des Feldeffekttransistors (20) auf den Soll-Drainstrom, wobei der Soll-Drainstrom einem solchen Drainstrom entspricht, bei dem der Zusammenhang zwischen Steilheit und Drainstrom des Feldeffekttransistors (20) im wesentlichen temperaturunabhängig ist.

2. Temperaturkompensationsschaltung für eine Feldeffekttransistor-Verstärkerschaltung gemäß Anspruch 1, bei der der Steuereingang des Feldeffekttransistors (20) die Gate-Elektrode (G1) desselben ist.

3. Temperaturkompensationsschaltung für eine Feldeffekttransistor-Verstärkerschaltung gemäß Anspruch 1 oder 2, bei der der Feldeffekttransistor ein Dual-Gate-MOSFET ist.

4. Temperaturkompensationsschaltung für eine Feldeffekttransistor-Verstärkerschaltung gemäß einem der Ansprüche 1 bis 3, bei der die Stromerfassungseinrichtung (20) durch eine Stromspiegelschaltung (T1, T2, R4) gebildet ist.

5. Temperaturkompensationsschaltung für eine Feldeffekttransistor-Verstärkerschaltung gemäß Anspruch 1, bei der die Reglereinrichtung durch einen Proportional-Integral-Regler (OP1, C2, R3) gebildet ist.

6. Temperaturkompensationsschaltung für eine Feldeffekttransistor-Verstärkerschaltung gemäß Anspruch 5, bei der die charakteristischen Größen des Proportional-Integral-Reglers derart eingestellt sind, daß derselbe im aperiodischen Grenzfall arbeitet.

7. Temperaturkompensationsschaltung für eine Feldeffekttransistor-Verstärkerschaltung gemäß Anspruch 1, bei der die Reglereinrichtung einen weiteren Eingang aufweist, an den ein den Soll-Drainstrom bestimmendes Signal anlegbar ist.
